# EUROPEAN PATENT APPLICATION

(11) **EP 4 590 087 A1**
(43) Date of publication of application: **23.07.2025**
(21) Application number: 24182987.8
(22) Date of filing: 19.06.2024
(51) Int. Cl.: H10D 62/10, H10D 8/80

(54) **SILICON CONTROL RECTIFIERS**

(30) Priority: 16.01.2024 US 202418413747
(71) Applicant: GlobalFoundries U.S. Inc., Malta, NY 12020 (US)
(72) Inventor: CHOPPALLI, Vvss Satyasuresh, 560045 Bangalore (IN); DUTTA, Anupam, 560045 Bangalore (IN); KRISHNASAMY, Rajendran, Essex Junction, VT, 05452 (US)
(74) Representative: Lambacher, Michael

(57) **Abstract**

The present disclosure relates to semiconductor structures and, more particularly, to a device triggered silicon control rectifiers (SCR) and methods of manufacture. The structure includes: a first device comprising a first shallow diffusion region of a first conductivity type within a first well of a second conductivity type and a second shallow diffusion region of the first conductivity type within the first well of the second conductivity type.

## Description

### BACKGROUND

The present disclosure relates to semiconductor structures and, more particularly, to a device triggered silicon control rectifiers (SCR) and methods of manufacture.

SCRs are used for electrostatic discharge (ESD) protection of integrated circuits (ICs) from the sudden flow of electricity caused by, for example, contact, electrical shorts, or dielectric breakdown. Because of high current handling ability per unit area of an SCR, ESD devices utilizing SCR can protect ICs from failure. These devices are most often used in high performance analog and radiofrequency (RF) designs for chips that have large signal swings, low leakage, and low capacitance. SCRs generally have high triggering voltage.

### SUMMARY

In an aspect of the disclosure, a structure comprises: a first device comprising a first shallow diffusion region of a first conductivity type within a first well of a second conductivity type and a second shallow diffusion region of the first conductivity type within the first well of the second conductivity type.
Additional features of the structure are set forth in dependent claims 2 to 11.

In an aspect of the disclosure, a structure comprises: a first device connecting to an anode and a cathode, the first device comprising: a first shallow diffusion region of a first conductivity type within a well of a second conductivity type; and a second shallow diffusion region of the first conductivity type within the well of the second conductivity type and spaced apart from the first shallow diffusion region; and a second device comprising: a contact region of a second conductivity type connecting to a well of the first conductivity type; the well of the second conductivity type; and the first shallow diffusion region of the first conductivity type within the well of a second conductivity type.
Additional features of the structure are set forth in dependent claims 13 and 14.

In an aspect of the disclosure, a method comprises: forming a first device comprising a first shallow diffusion region of a first conductivity type within a first well of a second conductivity type; and forming a second device comprising the first shallow diffusion region and a second shallow diffusion region of the first conductivity type within the first well of the second conductivity type.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1A shows a cross-sectional view of a device and respective manufacturing processes in accordance with aspects of the present disclosure.
FIG. 1B shows a top view of the device of FIG. 1A along line A-A;
FIG. 2 shows a device in accordance with another aspect of the present disclosure.
FIG. 3 shows a device in accordance with a further aspect of the present disclosure.
FIG. 4 shows a device in accordance with yet an additional aspect of the present disclosure.

### DETAILED DESCRIPTION

The present disclosure relates to semiconductor structures and, more particularly, to a device triggered silicon control rectifiers (SCR) and methods of manufacture. More specifically, the SCR includes a shallow diffusion region within a well of an opposite conductivity type. A triggering device includes multiple shallow diffusion regions within a well of an opposite conductivity type. A first of the shallow diffusion regions is coupled to an anode and a second of the shallow diffusion regions is coupled to a cathode. Advantageously, the SCRs described herein exhibit improved trigger current (It2) and a tunable trigger voltage (Vtrigger). Also, due to the use of shallow diffusions, the device offers lower capacitance than standard semiconductor-on-insulator (SOI) SCRs. The SCRs may also utilize less space on the chip.

The devices of the present disclosure can be manufactured in a number of ways using a number of different tools. In general, though, the methodologies and tools are used to form structures with dimensions in the micrometer and nanometer scale. The methodologies, i.e., technologies, employed to manufacture the devices of the present disclosure have been adopted from integrated circuit (IC) technology. For example, the structures are built on wafers and are realized in films of material patterned by photolithographic processes on the top of a wafer. In particular, the fabrication of the devices uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

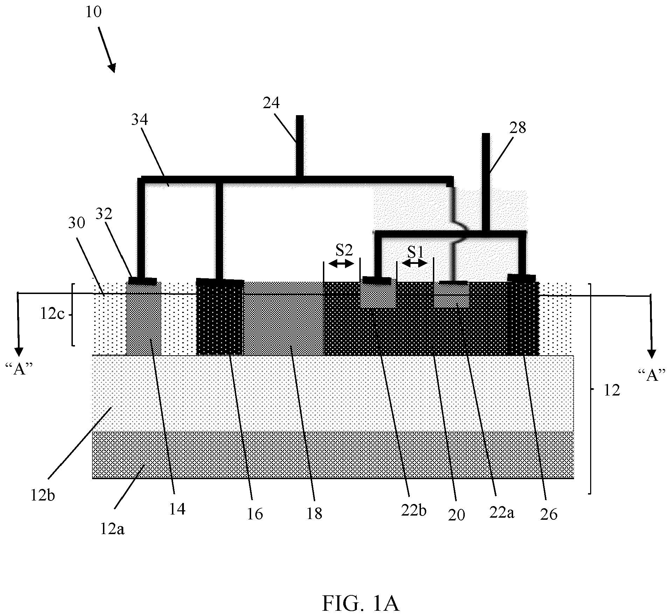

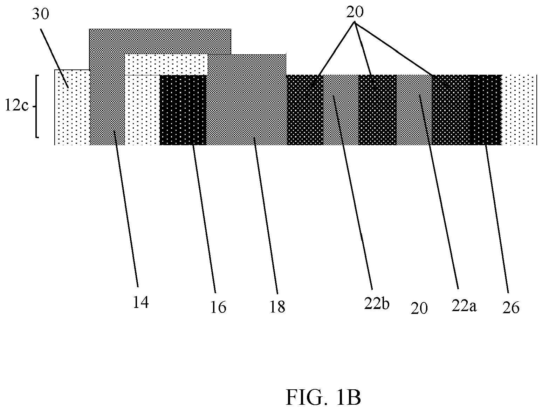

FIGS. 1A and 1B show a device and respective manufacturing processes in accordance with aspects of the present disclosure. More specifically, FIG. 1A shows a cross-sectional view of an SCR (e.g., PNPN) with a triggering device (e.g., NPN); whereas FIG. 1B shows a top view of the SCR and triggering device along line A-A.

More specifically, the device 10 shown in FIGS. 1A and 1B, include a substrate 12, which may comprise semiconductor-on-insulator technology. For example, the substrate 12 includes, from bottom to top, a handle substrate 12a, a buried insulator layer 12b and a top semiconductor layer 12c. The handle substrate 12a provides mechanical support to the buried insulator layer 12b and the top semiconductor layer 12c.

The handle substrate 12a and the top semiconductor layer 12c may include a semiconductor material such as, for example, Si, Ge, SiGe, SiC, SiGeC, a III-V compound semiconductor, an II-VI compound semiconductor or any combinations thereof. In preferred embodiments, the top semiconductor layer 12c comprises Si with any suitable single crystallographic orientation (e.g., <100>, <110>, <111>, or <001>). The buried insulator layer 12b may include a dielectric material such as silicon dioxide, silicon nitride, silicon oxynitride, boron nitride or a combination thereof. In preferred embodiments, the buried insulator layer 12b is a buried oxide layer (BOX).

The buried insulator layer 12b may be formed by a deposition process, such as chemical vapor deposition (CVD), plasma enhanced chemical vapor deposition CVD (PECVD) or physical vapor deposition (PVD). In another embodiment, the buried insulator layer 12b may be formed using a thermal growth process, such as thermal oxidation, to convert a surface portion of the handle substrate 12a. In yet another embodiment, the buried insulator layer 12b can be formed by implanting oxygen atoms into a bulk semiconductor substrate and thereafter annealing the structure. The top semiconductor layer 12c can be formed by a deposition process, such as CVD or PECVD. Alternatively, the top semiconductor layer may be formed using a smart cut process where two semiconductor wafers are bonded together with an insulator in between.

Still referring to FIGS. 1A and 1B, the top semiconductor layer 12c includes a plurality of wells and diffusion regions forming a PNPN device (e.g., SCR), which may be triggered by an NPN device. The PNPN device (e.g., SCR) and NPN device may be lateral devices. For example, the PNPN device includes a P+ contact region 16 within an N-well 18, a P-well 20 and a shallow N+ diffusion region 22b within the P-well 20. The NPN device, on the other hand, includes the shallow N+ diffusion regions 22a, 22b in the P-well 20. In embodiments, the N+ diffusion regions 22a, 22b may have the same conductivity type and doping concentration. As described in more detail herein, the shallow N+ diffusion region 22a may be connected to an anode 24 and the shallow N+ diffusion region 22b may be connect to a cathode 28.

In FIGS. 1A and 1B, an N+ contact region 14 is electrically connected (e.g., abuts from a top view) to the N-well 18 and a P+ contact region 26 is electrically connected to the P-well 20. As to the latter, for example, the P+ contact region 26 may be within the P-well 20. Both the N+ contact region 14 and the P+ contact region 26 may create additional well resistance to the respective wells 18, 20. In embodiments, the P+ contacts regions 16, 26 and N+ contact region 14 are heavily doped regions (compared to the N-well 18 and P-well 20).

As shown further in FIG. 1A, in embodiments, the N+ contact region 14, P+ contact region 16 and shallow N+ diffusion region 22a in the P-well 20 may be connected to the anode 24. In addition, the shallow N+ diffusion region 22b in the P-well 20 and the P+ contact region 26 may be electrically connected to the cathode 28.

The shallow N+ diffusion regions 22a, 22b preferably extend only partially into the P-well 20, e.g., the N+ diffusion regions 22a, 22b do not extend to the buried insulator layer 12b and should be isolated from one another by the P-well 20. Also, in embodiments, the N+ diffusion regions 22a, 22b are spaced apart by distance S1 and the N+ diffusion region 22b is spaced away from the N-well 18 by distance S2. In embodiments, S1 is greater than 0 to ensure that the N+ diffusion regions 22a, 22b are not shorted. The distance S2 may also be a minimal critical dimension as should be understood by those of skill in the art. In embodiments, the distances S1 and S2 are adjustable in order to tune the trigger voltage of the device. For example, a smaller distance S2 results in a lower trigger voltage; whereas a larger distance S2 results in a higher trigger voltage.

The wells, diffusion regions and N+/P+ contact regions may be formed by conventional ion implantation processes. For example, the ion implantation processes can introduce a concentration of a dopant of different (e.g., opposite) conductivity types in the top semiconductor layer 12c. In embodiments, respective patterned implantation masks may be used to define selected areas exposed for the implantations as is known in the art. The implantation masks may include a layer of a light-sensitive material, such as an organic photoresist, applied by a spin coating process, pre-baked, exposed to light projected through a photomask, baked after exposure, and developed with a chemical developer. Each of the implantation masks has a thickness and stopping power sufficient to block masked areas against receiving a dose of the implanted ions. The P-well 20 and P+ contact regions 16, 26 are doped with p-type dopants, e.g., Boron (B), and the N-well 18, N+ diffusion regions 22a, 22b and N+ contact region 14 are doped with n-type dopants, e.g., Arsenic (As), Phosphorus (P) and Antimony (Sb), among other suitable examples.

Still referring to FIGS. 1A and 1B, shallow trench isolation structures 30 are formed in the top semiconductor layer 12c. The shallow trench isolation structures 30 may isolate the N+ contact region 14 from the P+ contact region 16, in addition to being adjacent to these regions on either side. In this way, the shallow trench isolation structures 30 isolate the N+ contact region 14 and P+ contact regions 16, 26.

The shallow trench isolation structures 30 can be formed by conventional lithography, etching and deposition methods known to those of skill in the art. For example, a resist formed over the top semiconductor layer 12c is exposed to energy (light) and developed utilizing a conventional resist developer to form a pattern (opening). An etching process with a selective chemistry, e.g., reactive ion etching (RIE), will be used to transfer the pattern from the patterned photoresist layer to the top semiconductor layer 12c (extending to the buried insulator layer 12b) to form one or more trenches in the top semiconductor layer 12c. Following the resist removal by a conventional oxygen ashing process or other known stripants, an insulator material (e.g., SiOz) can be deposited in the trenches by any conventional deposition processes, e.g., chemical vapor deposition (CVD) processes. Any residual material on the surface of the top semiconductor layer 12c can be removed by conventional chemical mechanical polishing (CMP) processes.

FIG. 1A further shows silicide contacts 32 on the N+ contact region 14, P+ contact regions 16, 26 and shallow N+ diffusion regions 22a, 22b. As should be understood by those of skill in the art, the silicide process begins with deposition of a thin transition metal layer, e.g., nickel, cobalt or titanium, over fully formed and patterned semiconductor devices (e.g., d N+ contact region 14, P+ contact regions 16, 26 and shallow N+ diffusion regions 22a, 22b). After deposition of the material, the structure is heated allowing the transition metal to react with exposed silicon (or other semiconductor material as described herein) in the active regions of the semiconductor device (e.g., source, drain, gate contact region) forming a low-resistance transition metal silicide. Following the reaction, any remaining transition metal is removed by chemical etching, leaving silicide contacts 32 on the N+ contact region 14, P+ contact regions 16, 26 and shallow N+ diffusion regions 22a, 22b. As should be understood by those of skill in the art, the N+ diffusion regions 22a, 22b are spaced apart by distance S2 such that the silicide contacts 32 will not contact one another.

FIG. 1A also shows wiring structures 34 connecting between the N+ contact region 14, P+ contact regions 16, 26, shallow N+ diffusion regions 22a, 22b and a respective anode 24 and cathode 28. The wiring structures 34 may be formed within interlevel dielectric material using conventional lithography, etching and deposition methods as is known in the art such that no further explanation is required for a complete understanding of the present disclosure.

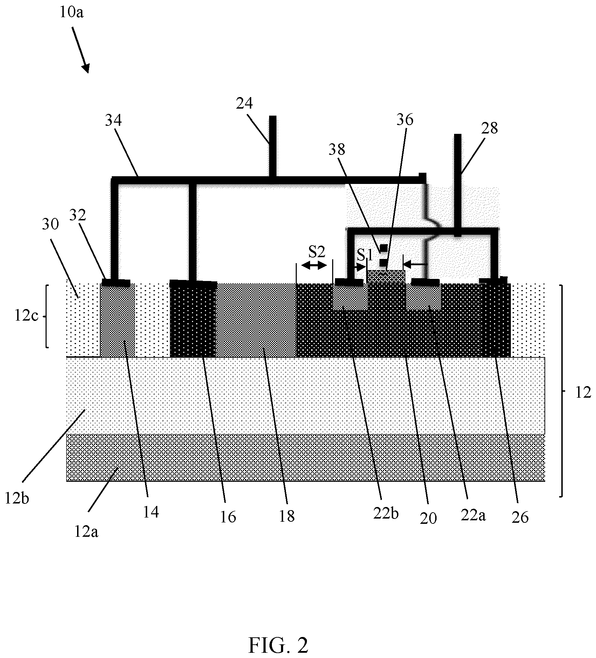

FIG. 2 shows a device in accordance with another aspect of the present disclosure. In the device 10a of FIG. 2, a gate structure 36 may be provided over the P-well 20 and between the shallow N+ diffusion regions 22a, 22b. In embodiments, the gate structure 36 may be a polysilicon gate structure that is either floating or electrically connected to the cathode 28 as shown by the dashed line (e.g., wiring structure) 38. In embodiments, the gate structure 36 may act as a silicide block, preventing the silicide contact 32 from forming on the top semiconductor layer 12c, extending between and making contact to both the shallow N+ diffusion regions 22a, 22b.

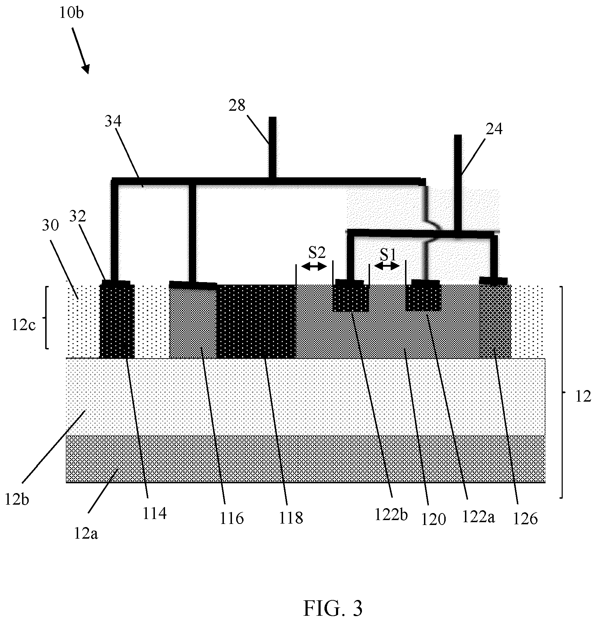

FIG. 3 shows a device and respective manufacturing processes in accordance with aspects of the present disclosure. More specifically, the device 10b includes a plurality of wells and diffusion regions in the top semiconductor layer 12c forming an NPNP device (e.g., SCR), which may be triggered by a PNP device. The NPNP device (e.g., SCR) and PNP device may be lateral devices.

As shown in FIG. 3, the NPNP device and PNP device are provided in the top semiconductor layer 12c, over a buried insulator layer 12b which, in turn, is provided on a handle substrate 12a. In embodiments, the NPNP device includes an N+ contact region 116 in the P-well 118, the N-well 120 and the shallow P+ diffusion region 122b. The PNP device, on the other hand, includes the shallow P+ diffusion regions 122a, 122b in the N-well 120. The shallow P+ diffusion region 122b may be connected to an anode 24 and the shallow P+ diffusion region 122a may be connected to a cathode 28.

In embodiments, the N+ contact region 116 is in the P-well 118, and the P+ contact region 114 is electrically connected (e.g., abuts from a top view similar to that shown in FIG. 1B for the P+ contact 16 to the P-well 18) to the P-well 118. The P-well 118 also abuts the N-well 120. The P+ contact region 114, N+ contact region 116 and shallow P+ diffusion region 122a in the N-well 120 may be connected to the cathode 28; whereas the shallow P+ diffusion region 122b in the N-well 120 and the N+ contact region 126 in the N-well 120 may be electrically connected to the anode 24. As in the previous embodiments, the shallow P+ diffusion regions 122a, 122b should preferably not extend to the buried insulator layer 12b and should preferably be isolated from one another by the N-well 120. Also, in embodiments, the N+ contacts regions 116, 126 and P+ contact region 114 are heavily doped regions (compared to the P-well 118 and N-well 120). Moreover, in embodiments, the P+ diffusion regions 122a, 122b may have the same conductivity type and doping concentration.

In further embodiments, the P+ diffusion regions 122a, 122b are spaced apart by distance S1 and the P+ diffusion region 122b is spaced away from the P-well 118 by distance S2. In embodiments, S1 is greater than 0 to ensure that the P+ diffusion regions 122a, 122b are not shorted. The distance S2 may be a minimal critical dimension as should be understood by those of skill in the art. As in the previously described structures 10, 10a, the distances S1 and S2 are adjustable in order to tune the trigger voltage of the device. For example, a smaller distance S2 results in a lower trigger voltage; whereas a larger distance S2 results in a higher trigger voltage. Also, the wells, diffusion regions and N+/P+ contact regions may be formed by conventional ion implantation processes.

Still referring to FIG. 3, shallow trench isolation structures 30 are formed in the top semiconductor layer 12c. The shallow trench isolation structures 30 may be provided between and isolate the P+ contact region 114 and N+ contact region 116, in addition to being adjacent to these regions on either side. In this way, the shallow trench isolation structures 30 isolate the P+ contact region 14 and N+ contact regions 116, 126.

FIG. 3 further shows silicide contacts 32 on the P+ contact region 114, N+ contact regions 116, 126 and shallow P+ diffusion regions 122a, 122b. Wiring structures 34 connect between the P+ contact region 114, N+ contact regions 116, 126 and shallow P+ diffusion regions 122a, 122b and a respective anode 24 and cathode 28.

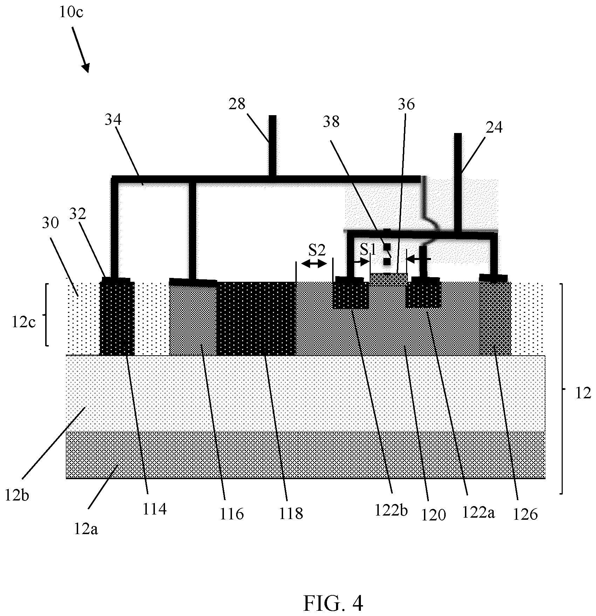

FIG. 4 shows a device 10c similar to the device 10b of FIG. 3. In the device 10c, a gate structure 36 may be provided over the N-well 120 and between the shallow P+ diffusion regions 122a, 122b. In embodiments, the gate structure 36 may be a polysilicon gate structure that is either floating or connected to the anode 24 as shown by the dashed line (e.g., wiring structure) 38. In embodiments, the gate structure 36 may act as a silicide block, preventing the silicide contact 32 from extending between and making contact to both the shallow P+ diffusion regions 122a, 122b.

The devices can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a first device comprising a first shallow diffusion region of a first conductivity type within a first well of a second conductivity type and a second shallow diffusion region of the first conductivity type within the first well of the second conductivity type.

2. The structure of claim 1, further comprising a second device comprising the first shallow diffusion region in the first well.

3. The structure of claim 2, wherein the first device comprises an NPN and the second device comprises a PNPN.

4. The structure of one of claims 1 to 3, wherein the first shallow diffusion region and the second shallow diffusion region comprise an N-type dopant and the first well comprises a P-type dopant, and, optionally, wherein the first shallow diffusion region connects to a cathode and the second shallow diffusion region connects to an anode.

5. The structure of one of claims 2 to 4, wherein the second device comprises a P+ contact region electrically connected to an N-well, and the first shallow diffusion region in the first well.

6. The structure of claim 5, wherein the first shallow diffusion region comprises an n-type dopant and the first well comprises a P-well, and, optionally, wherein the first shallow diffusion region connects to a cathode.

7. The structure of one of claims 1 to 6, wherein the first shallow diffusion region and the second shallow diffusion region are spaced apart from one another within the first well, and are remotely positioned away from and above an underlying buried insulator layer.

8. The structure of one of claims 1 to 7, further comprising a gate structure over the first well and between the first shallow diffusion region and the second shallow diffusion region, and, optionally, wherein the gate structure is one of floating and connected to a cathode.

9. The structure of claim 2, wherein the first device comprises an PNP and the second device comprises a NPNP, and wherein the first shallow diffusion region and the second shallow diffusion region of the first device comprise a P-type dopant and the first well comprises an N-type dopant.

10. The structure of claim 9, wherein the first shallow diffusion region electrically connects to an anode and the second shallow diffusion region electrically connects to a cathode, and/or wherein the second device comprises an N+ contact region electrically connecting to a P-well, and the first shallow diffusion region comprising a P-type dopant within the first well which comprises an N-well.

11. The structure of one of claims 1 to 10, further comprising contact regions electrically connected to the first well and a second well of the first conductivity type.

12. A structure comprising:
a first device connecting to an anode and a cathode, the first device comprising:
a first shallow diffusion region of a first conductivity type within a well of a second conductivity type; and
a second shallow diffusion region of the first conductivity type within the well of
the second conductivity type and spaced apart from the first shallow diffusion region; and a second device comprising:
a contact region of a second conductivity type connecting to a well of the first conductivity type;
the well of the second conductivity type; and
the first shallow diffusion region of the first conductivity type within the well of a second conductivity type.

13. The structure of claim 12, further comprising a gate structure between the first shallow diffusion region and the second shallow diffusion region.

14. The structure of claim 12 or claim 13, wherein the first device comprises an NPN and the second device comprises a PNPN, or wherein the first device comprises a PNP and the second device comprises a NPNP.

15. A method comprising:
forming a first device comprising a first shallow diffusion region of a first conductivity type within a first well of a second conductivity type; and
forming a second device comprising the first shallow diffusion region and a second shallow diffusion region of the first conductivity type within the first well of the second conductivity type.
